# EUROPEAN PATENT SPECIFICATION

(11) **EP 1 865 554 B1**
(45) Date of publication and mention of the grant of the patent: **11.01.2017**
(21) Application number: 06011932.8
(22) Date of filing: 09.06.2006
(51) Int. Cl.: H01L 27/115, H01L 27/105

(54) **Semiconductor memory device and method for operation**
Halbleiterspeicheranordnung sowie Methode zu deren Betrieb
Dispositif de mémoire à semi-conducteurs et son mode de fonctionnement

(43) Date of publication of application: 12.12.2007
(73) Proprietor: ams AG, 8141 Unterpremstätten (AT)
(72) Inventor: Leisenberger, Friedrich Peter, 8045 Graz (AT); Park, Jong Mun, 8010 Graz (AT)
(74) Representative: Epping - Hermann - Fischer

(56) References cited:
- JP-A- 2005 142 362
- US-A- 5 668 755
- US-A1- 2004 201 077
- US-A1- 2004 268 025

## Description

The invention concerns semiconductor memory devices having an addressing circuitry of complementary transistor devices providing high voltages for a non-volatile memory cell, especially an EEPROM memory cell.

Non-volatile memories like EEPROMs, especially when arranged in a flash array, necessitate the application of relatively high voltages provided by the addressing circuitry. The addressing of the memory cells in read, write, and erase processes makes use of logic circuitry, which is usually realized with complementary transistor devices.

US 5,790,455 and US 5,986,931 describe an integrated concept of non-volatile memories, which are integrated with complementary logic and can be produced in a standard CMOS process using a p-doped substrate with n-wells and p-wells. The n-channel high-voltage transistors are arranged in a p-well or directly in the substrate and are therefore on the substrate potential during the operation of the device. This may cause negative effects on the logic circuitry if ground bounces or substrate currents occur.

US 2002/048192 describes a flash memory cell concept, which reduces the voltages that are necessary in erase and program steps, but the memory block is not fully isolated from the substrate. US 6,133,604 describes a so-called ETOX cell, which is arranged in a p-well within a deep n-well, which is located in a p-substrate. The p-wells of the cells of a column are connected to a common p-well bias line. The forward-biased deep-n-well-to-p-well junction provides "seed" electrons injecting and diffusing into the p-well. This enables a special programming method by the injection of substrate hot electrons. To this purpose, the control-gate is biased high enough so that the channel is inverted. The source and drain junctions are biased high enough for accelerating the seed electrons towards the channel area and finally injecting the electrons into the floating-gate. The control-gate potential establishes an electric field across the tunnel oxide for assisting hot electrons to inject towards the floating-gate.

US 2004/0201077 A1 describes a semiconductor integrated circuit device comprising nonvolatile memory cells arranged in a p-well, which is arranged in a sequence of wells of alternating signs of conductivity. Further wells are provided for a circuitry comprising NMOS and PMOS devices.

US 2004/0268025 A1 discloses a non-volatile flash memory comprising a plurality of memory blocks, in which information is rewritable by electrical erasing/writing.

JP 2005 142362 A discloses a memory device comprising a substrate with a main surface, a first well that is doped for n-type conductivity being arranged at the same surface, a second well that is doped for p-type conductivity being arranged at the main surface within the first well, a non-volatile memory cell being disposed in the second well and an addressing circuitry of complementary transistor devices arranged in the first and the second well.

It is an object of this invention to provide a semiconductor memory device with non-volatile memory cells and integrated addressing circuitry with improved reliability and sufficient robustness in performance suitable for demanding applications as in automotive or industrial environments.

This object is achieved by the semiconductor memory device according to claim 1. Further embodiments are derived from the dependent claims.

The semiconductor memory device has two doped wells at a main surface of a semiconductor substrate. The first well is doped for n-type conductivity and the second well is doped for p-type conductivity and arranged within the first well. At the main surface, the n-channel transistors and p-channel transistors of the addressing logic circuitry are arranged in the corresponding wells. At least one non-volatile memory cell, especially an EEEPROM memory cell, is disposed in the first well and formed as a p-channel transistor structure. Because of the arrangement of the memory cell in the deeper well of n-type conductivity, the whole logic circuitry can be fully isolated from the substrate voltage. If the ground potential is applied to the substrate, the first well, which is the deep n-well, can be set to a positive voltage of, for example, typically about 10 V, and can be extended over 50 V. This means that voltages can be applied to the logic circuitry in such a manner that the usual operation of the circuitry is possible, while the absolute level of the electric potentials can be increased above the substrate potential, so that the logic devices are fully isolated from the substrate. Thus, the non-volatile memory block can be operated alternatively at or above the substrate potential and is therefore fully isolated. This is of advantage, if the non-volatile memory block is embedded in a system on chip (SOC) with high-voltage capability.

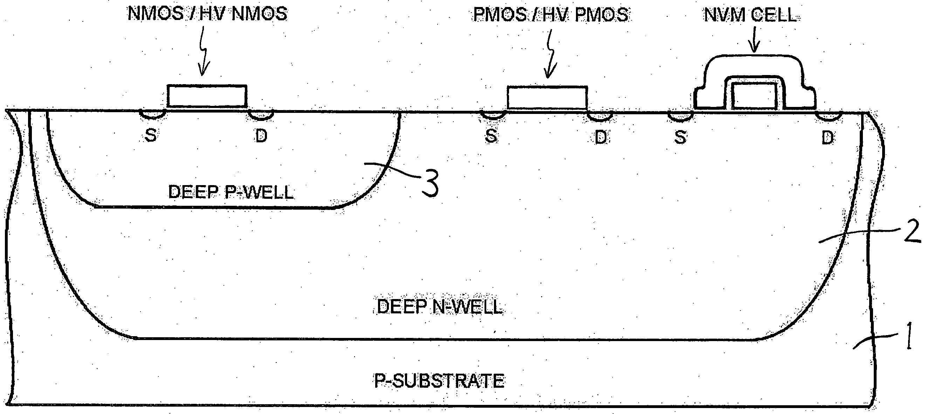

Examples of preferred embodiments will subsequently be described in conjunction with the appended figure showing a cross-section of the semiconductor memory device.

The figure shows a cross-section of a semiconductor substrate 1 with a first well 2 and a second well 3, which is arranged within the first well. In this example, the substrate 1 is provided with a basic doping of p-type conductivity. The first well 2 is a deep n-well, and the second well 3 is a deep p-well. PMOS devices, especially high-voltage PMOS devices, are arranged in the first well, and NMOS devices, especially high-voltage NMOS devices, are arranged in the second well 3. The memory device, designated as NVM CELL (non-volatile memory cell), comprises at least one non-volatile memory cell, which is disposed in the first well and designed to be a p-channel device.

Preferred embodiments of the semiconductor memory device are provided with an array of non-volatile memory cells, especially EEPROM cells, which can especially be designed as a flash array, so that the whole array or blocks of memory cells are erased in common. The memory cell can in principle be any type of non-volatile memory cell, preferably provided for an electric erasure and programming. A usual EEPROM memory cell is formed with a control-gate electrode and a floating-gate electrode. The floating-gate electrode is electrically insulated and provided to store charge carriers defining a programmed state, in which the threshold voltage of the transistor structure is modified.

Memory cells of n-channel type can be arranged in the second well. The number of wells is not limited; pluralities of deep first wells of n-type conductivity and second wells of p-type conductivity, which are arranged within the first wells, can be provided.

An electric circuit is preferably provided for an application of different electric potentials to the substrate and to the wells. It is especially favorable to apply a higher voltage to the first well 2 than to the substrate 1. If the substrate potential is the ground potential, for instance, the voltage that is applied to the first well 2 is preferably positive and can be typically at least 8 V above the ground potential. This device can be realized for example in a standard 0.35 *µ*m and 0.18 *µ*m CMOS process.

In an especially adapted method for operating such a semiconductor memory device, a voltage that is higher than the substrate voltage is applied to the first well 2. In order to prevent pn-diode turn-on, the first well 2 and the second well 3 are on the same potential; in general, the second well 3 is on a lower potential than the first well 2. If the second well 3 is used as the anode of a diode, the potential can be higher than the potential of the first well 2.

This invention enables the full integration of non-volatile memories of p-channel type together with fully isolated NMOS devices of the addressing logic circuitry.

### List of reference numerals

- 1: substrate
- 2: first well
- 3: second well
- NVM CELL: non-volatile memory cell

## Claims

1. Semiconductor memory device, comprising:
- a substrate (1) with a main surface,
- a first well (2) that is doped for n-type conductivity being arranged at the main surface,
- a second well (3) that is doped for p-type conductivity being arranged at the main surface within the first well,
- an addressing circuitry of complementary transistor devices (NMOS, PMOS) arranged in the first well and the second well,
**characterised in that** at least one non-volatile memory cell(NVM CELL)is disposed in the first well (2) and is designed to be a p-channel device.

2. Semiconductor memory device according to claim 1, further comprising:
- high-voltage PMOS devices arranged in the first well,
- high-voltage NMOS devices arranged in the second well.

3. Semiconductor memory device according to claim 1 or 2, further comprising:
memory cells of n-channel type arranged in the second well (3).

4. Semiconductor memory device according to one of claims 1 to 3, further comprising:
pluralities of first wells (2) of n-type conductivity and second wells (3) of p-type conductivity, the second wells being arranged within the first wells.

## Patentansprüche

1. Halbleiterspeicherelement, Folgendes umfassend:
- ein Substrat (1) mit einer Hauptfläche,
- eine für eine Leitfähigkeit des n-Typs dotierte erste Wanne (2), die an der Hauptfläche angeordnet ist,
- eine für eine Leitfähigkeit des p-Typs dotierte zweite Wanne (3), die an der Hauptfläche in der ersten Wanne angeordnet ist,
- eine Adressierungsschaltung aus komplementären Transistorelementen (NMOS, PMOS), die in der ersten Wanne und der zweiten Wanne angeordnet sind,
**dadurch gekennzeichnet, dass** mindestens eine nichtflüchtige Speicherzelle (NVM CELL) in der ersten Wanne (2) angeordnet und als p-Kanal-Element konzipiert ist.

2. Halbleiterspeicherelement nach Anspruch 1, darüber hinaus umfassend:
- Hochspannungs-PMOS-Elemente, die in der ersten Wanne angeordnet sind,
- Hochspannungs-NMOS-Elemente, die in der zweiten Wanne angeordnet sind.

3. Halbleiterspeicherelement nach Anspruch 1 oder 2, darüber hinaus umfassend:
Speicherzellen eines n-Kanal-Typs, die in der zweiten Wanne (3) angeordnet sind.

4. Halbleiterspeicherelement nach einem der Ansprüche 1 bis 3, darüber hinaus umfassend:
mehrere erste Wannen (2) der Leitfähigkeit des n-Typs und mehrere zweite Wannen (3) der Leitfähigkeit des p-Typs, wobei die zweiten Wannen in den ersten Wannen angeordnet sind.

## Revendications

1. Dispositif de mémoire à semiconducteur, comprenant:
- un substrat (1) présentant une surface principale,
- un premier puits (2) qui est dopé pour une conductivité de type n, agencé au niveau de la surface principale,
- un deuxième puits (3) qui est dopé pour une conductivité de type p, agencé au niveau de la surface principale à l'intérieur du premier puits,
- un circuit d'adressage de dispositifs de transistor complémentaire (NMOS, PMOS) agencés dans le premier puits et le deuxième puits,
**caractérisé en ce qu'**au moins une cellule de mémoire non volatile (NVM CELL) est disposée dans le premier puits (2) et est conçue pour être un dispositif à canal p.

2. Dispositif de mémoire à semiconducteur selon la revendication 1, comprenant en outre:
- des dispositifs PMOS à haute tension agencés dans le premier puits,
- des dispositifs NMOS à haute tension agencés dans le deuxième puits.

3. Dispositif de mémoire à semiconducteur selon la revendication 1 ou 2, comprenant en outre:
des cellules de mémoire de type de canal n agencées dans le deuxième puits (3).

4. Dispositif de mémoire à semiconducteur selon l'une des revendications 1 à 3, comprenant en outre:
des pluralités de premiers puits (2) de conductivité de type n et des deuxièmes puits (3) de conductivité de type p, les deuxièmes puits étant agencés à l'intérieur des premiers puits.
